# EUROPEAN PATENT SPECIFICATION

(11) **EP 0 846 334 B1**
(45) Date of publication and mention of the grant of the patent: **13.11.2002**
(21) Application number: 96929234.1
(22) Date of filing: 09.08.1996
(51) Int. Cl.: H01L 21/00

(54) **Procedure for drying substrates**
Verfahren zum Trocknen von Substraten
Procedure de sachage de substrats

(30) Priority: 23.08.1995 DE 19531031
(43) Date of publication of application: 10.06.1998
(60) Divisional application: 01130669.3
(73) Proprietor: Ictop Entwicklungs GmbH, 95490 Mistelgau (DE)
(72) Inventor: SCHELLENBERGER, Wilhelm, D-95489 Mistelgau (DE); HERRMANNSDÖRFER, Dieter, D-95489 Mistelgau (DE)
(74) Representative: Melzer, Wolfgang, Dipl.-Ing.
(86) International application number: EP9603541
(87) International publication number: WO97008742

(56) References cited:
- EP-A- 0 385 536
- WO-A-95/08406
- US-A- 4 722 752
- PATENT ABSTRACTS OF JAPAN vol. 16, no. 269 (C-0952), 17 June 1992 & JP,A,04 066175 (SEIKO EPSON CORP), 2 March 1992,

## Description

The invention relates to a procedure for cleanly drying surfaces of materials, such as semiconductors, ceramics, metals, glasses, plastics and, in particular, silicon wafers and laser disks, wherein a substrate is dipped in a liquid bath and its surfaces are dried as it is separated from the liquid, such as by directing a gas over the liquid surface, the gas being soluble in the liquid and lowering the surface tension of the liquid.

### Description of the Related Art

When producing microelectronic devices, silicon, which is usually in the form of monocrystalline wafers, is badly contaminated or damaged as a result of cutting, polishing, varnishing or similar procedures. For that reason, the silicon is usually cleaned in multiple steps, which are usually performed in liquid baths.

The different chemical treatments are usually selectively effective for different types of contaminants (i.e., particles, organic coatings, functional organic Si-CR₃ groups or groups of metals, which show similar chemical behavior with each other). The chemical treatments are typically separated by rinsing steps to make the silicon surface free of chemicals and to avoid mixtures of chemicals. Superior water purity is important to minimize the risk of recontamination by metals at pH neutrality.

The silicon is at risk of being recontaminated by contaminants, such as particles or metals, of a type that was removed during a prior phase of the cleaning sequence because of contamination present in subsequent rinsing steps or in chemicals, such as stabilizers for H₂O₂, used in the subsequent cleaning steps. The total cleaning sequence is finished by a drying step.

Many different drying procedures for silicon surfaces are known. These drying procedures include dry spinning by centrifugal forces and drying by solvents like trichlorethanol or methylenechloride. Furthermore, there are drying techniques using hot air, hot water or isopropyl alcohol. One disadvantage of these popular drying procedures is that immense stress is put on the silicon wafer by high mechanical forces. Accordingly, the danger of damaging the edges is high and, moreover, particle generation caused by movements of the silicon wafers relative to the carrier, is possible. In an extreme case, especially with thinner wafers or after thermal treatments, this stress can result in breaking of the wafer, thus destroying the complete drying object and contaminating the surrounding wafers with particles.

The drying procedures can also lead to high operating costs due to the use of expensive chemicals, the disposal of which is necessary. Finally, one disadvantage of all the procedures mentioned above is the danger of metallic recontamination of the cleaned surfaces during the drying process.

Known procedures for drying silicon are described in the article "Ultraclean Marangoni Drying in Gases and Liquids 3," in 'Particles in Gases and Liquids 3: Detection, . Characterization and Control', edited by K.L. Mittal, Plenum Press, New York, 1993, pages 269-282. The procedure described in this article entails dipping silicon wafers into a water bath and then removing the silicon wafers from the water bath by adding an isopropyl alcohol/nitrogen mixture over the surface of the bath. Isopropyl alcohol is soluble in water and lowers the surface tension when solved in water.

The known drying procedure is based on the so-called MARANGONI Principle or MARANGONI effect. This principle is based on the fact that there is a higher concentration of isopropyl alcohol on the slightly upwards curved area between the silicon surface and the water surface when the silicon wafers are removed from the water bath than on the water surface further away from the silicon surface. The higher concentration of isopropyl alcohol in the area between the silicon surface and the water surface causes a lower surface tension there than on the remaining water surface. This gradient in the surface tension causes the water to flow from the silicon surface to the remaining water surface, which results in the drying of the silicon surface. A disadvantage of this procedure is the metallic contamination of the water, which causes a metal contamination of the silicon surface as well. Furthermore, organic residue on the surface, which can be caused by the isopropyl alcohol, can occur. Thus, there is a need for methods for drying the silicon surface without metal and/or other contamination of the silicon surface.

EP 0 385 536-A1 discloses a process for drying a substrate with the aid of the MARANGONI effect, wherein the liquid bath, however, consists of water and the gas added over the surface of the liquid bath is an organic solvent. A disadvantage in this known procedure is that metal contamination of the water inevitably leads to a metal contamination of the substrate surface. Furthermore, organic residues on the surface cannot be excluded.

The underlying object of the present invention is therefore to provide a procedure for drying substrate surfaces according to the preambles of claim 1 which guarantees the maintenance of the degree of purity of the cleaned surfaces and the effective drying of the substrate with a simultaneous cleaning of the surface in an uncomplicated way.

This object is achieved by procedures for drying substrate surfaces according to claim 1.

Advantageous developments of the present invention are specified in the subclaims.

The invention provides procedures for drying surfaces. The procedures of the invention guarantee the purity of the cleaned surfaces and the effective drying of the surface. The invention is applicable to surfaces of many materials, including semiconductors, metals (particularly aluminum), plastics, glasses, and ceramics. The invention is particularly useful for drying and cleaning laser discs and semiconductor silicon wafers. It is to be understood that the invention is, however, useful in drying substrates of any adequate physical form, especially in the form of wafers, plates or discs.

The invention relates to a procedure for drying a substrate surface, wherein the substrate is dipped into a liquid bath and the substrate and the liquid are subsequently separated while providing a gas over the surface of the liquid, the gas being soluble in the liquid and lowering the surface tension of the liquid. For example, a semiconductor silicon wafer can be dried upon removal from a liquid bath comprising an aqueous HF solution with a concentration between .001% and 50% with an O₂/O₃ gas mixture provided over the surface of the aqueous HF solution.

### Brief Description of the Figures

The invention is now described by reference to the figures in which:
- Fig. 1: shows the removal of a silicon wafer from a bath with an aqueous HF solution by adding an O₂/O₃ gas mixture.
- Fig. 2: shows the removal of a silicon wafer from a bath with an aqueous HF solution without adding O₂/O₃.
- Fig. 3a-3c: shows the chemical processes of the cleaning or hydrophilizing of the silicon surface using the procedures according to the invention.

### Description of the Preferred Embodiment

In an embodiment, the gas mixture added over the surface of the HF solution contains O₂/O₃, and nitrogen or a similar gas can be used as a carrier gas. The carrier gas should be chemically inactive with the O₂/O₃ component of the gas mixture.

Suitable gases include air (N₂, O₂, CO₂), CO₂, He, Ne, Ar, Kr, Xe and Rn. The share of O₃ in the O₂/O₃ gas mixture is preferably 1 mg up to 0.5 g per liter of O₂/O₃ gas mixture. The gas mixture can consist of only O₂/O₃. If a carrier gas is used, however, the share of the O₂/O₃ gas mixture is preferably greater than 10%.

The silicon atoms active on the surface are changed into Si-H and Si-F bondings. The resulting hydrophobic surface character allows drying even at very low temperatures. The pH value < 7 of an aqueous HF solution during drying prevents metallic recontamination. Furthermore, the HF removes metal contamination in the liquid bath, which exists in an oxidized (= ionized) form like Fe, and keeps it in the liquid as metal fluoride complexes. If ozone is added over the surface of the aqueous HF solution in accordance with the first embodiment of the invention, it dissolves partly in the aqueous HF solution and transfers covalently bonded Si-Me combinations to ionic combinations, Me designing metals.

Moreover, when dissolving ozone in the aqueous HF solution, the MARANGONI effect occurs according to the ozone concentration. The silicon surface comes out hydrophilicly from the aqueous HF solution, meaning that it is wettable with water or aqueous solutions.

According to embodiments of the invention, separating the silicon from the aqueous HF solution can be done either by lifting the silicon out of the HF solution or by down flowing the HF solution, or by a combination of both.

With the procedure according to an embodiment of the invention, the relative speed of separation, which constitutes the speed of removal of the silicon from the solution or the speed of draining of solution from the bath, is about 1 to about 50 mm/sec and preferably about 3 to about 10 mm/sec. Such a low speed is an advantage, since the MARANGONI effect is especially effective at low speeds.

Furthermore, the aqueous HF solution can contain additives like organic compounds (such as alcohol, isopropyl alcohol and EDTA), organic acids (such as formic acid, acetic acid and citric acid), acids (such as HCI, H₃PO₄, HClO, HClO₂, HClO₃ and HClO₄), surfactants (cationic or anionic) or solid additives like NH₄F, provided they do not destroy the effects explained above and effective cleaning and drying of the silicon remain. Acids are added in the amount of 0% to about 50% weight, organic compounds are added in the amount of 0% to about 80% weight, surfactants are added in the amount of 0% to about 5% weight and solids are added in the amount of 0% to about 50% weight. Specific applications are possible, with which a stronger than mentioned effect or better cleaning and drying can be achieved by adding one or more acids to the aqueous HF solution. Preferred acids are HCl, H₂SO₄ and H₃PO₄ or mixtures thereof. However, any one or more of the acids described above can be added using the ranges listed above. Preferred mixtures of acids are HF/HCl, HF/HCl/H₂SO₄, HF/H₃PO₄, HF/H₃PO₄/HCl, HF/H₃PO₄/H₂SO₄ and HF/H₃ PO₄/HCl/H₂SO₄. Otherwise the HF solution can be skimmed out to a concentration of c=0 (pure water).

Furthermore, enriching or saturating the aqueous HF solution with ozone before dipping the silicon is an advantage, which results in cleaner silicon surfaces. Multiple mono layers of silicon are oxidized and then eroded. Thus, the cleaning is effective even for metals closely beneath the surface (subsurface contamination).

The HF-concentration is preferably between about .01% and about .1%. The range can be 0% (pure water) to 90% (concentrated HF).

A stable ozone content comparable with a saturated status can be achieved by continuously supplying the HF solution tank with an O₂/O₃ gas stream (for example, "bubbling"). Other parameters like temperature, concentration of HF and adding of additives (mainly surfactants) have an influence on the ozone content and the saturated status. A successful cleaning and drying procedure can be achieved with a continuous O₂/O₃ gas stream. In a preferred embodiment, the gas stream is in the range of about 50 to about 300 l/h and the ozone generation is in the range of about 10 to about 50 g/h.

An estimated value of the ozone concentration in the HF solution is in the range of 10 to 80 mg/l.

Another advantage of the invention is that the procedure can be carried out in a temperature range between 0 and 100 degrees Celsius, the preferred temperature being 20 to 50 degrees Celsius.

### Example

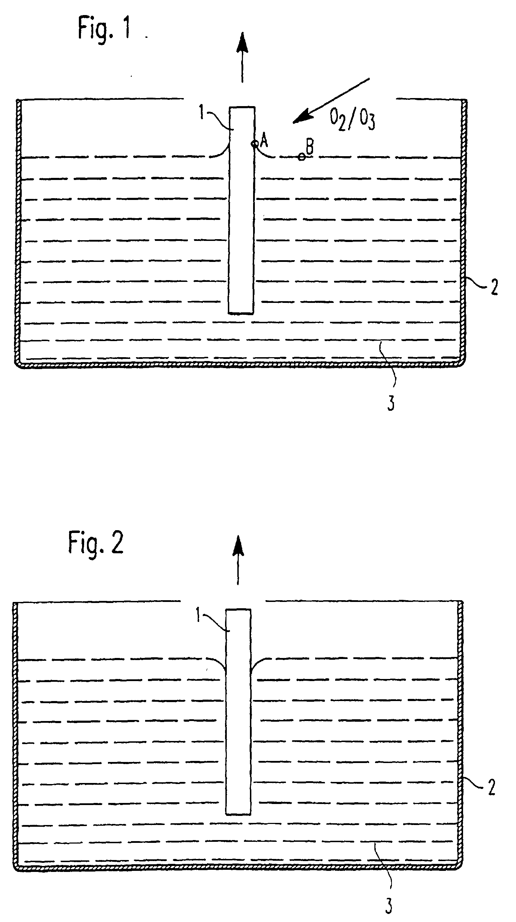

Fig. 1 shows a silicon wafer 1, which is slowly removed from a bath 2 with an aqueous HF solution 3 after being dipped completely into the bath. The direction of removal of the silicon wafer 1 is shown by the arrow pointing vertically upwards over the silicon wafer. The speed of removal is preferably about 3 to about 10 millimeters per second. The arrow diagonal to the silicon wafer surface shows the simultaneous adding of the O₂/O₃ gas mixture over the aqueous solution near the wafer surface.

When slowly removing the silicon wafer 1 from the aqueous HF solution 3, the surface of the aqueous HF solution sticks to the silicon surface, which is bent upwards. This is shown by an upwards curve of the liquid surface at the area between the surface of the solution and the surface of the silicon wafer 1. At point A more ozone is dissolved than at the other places of the surface of the solution, i.e., shown by point B. Since at point A there is a higher ozone concentration than at point B, there is a lower surface tension at point A than at point B. This gradient in the surface tension causes the aqueous HF solution to run from point A to point B, drying the silicon surface.

Fig. 2, not concerning the present invention, shows a silicon wafer 1, which is slowly removed from a bath 2 with an aqueous HF solution 3 after having been dipped completely into the bath. The direction of removal is shown by the arrow pointing vertically upwards over the silicon wafer. Because of the hydrophobicity of the silicon wafer, the surface of the liquid is bent downwards at the silicon surface. The hydrophilizing of the silicon surface by ozone takes place only after the drying process is finished.

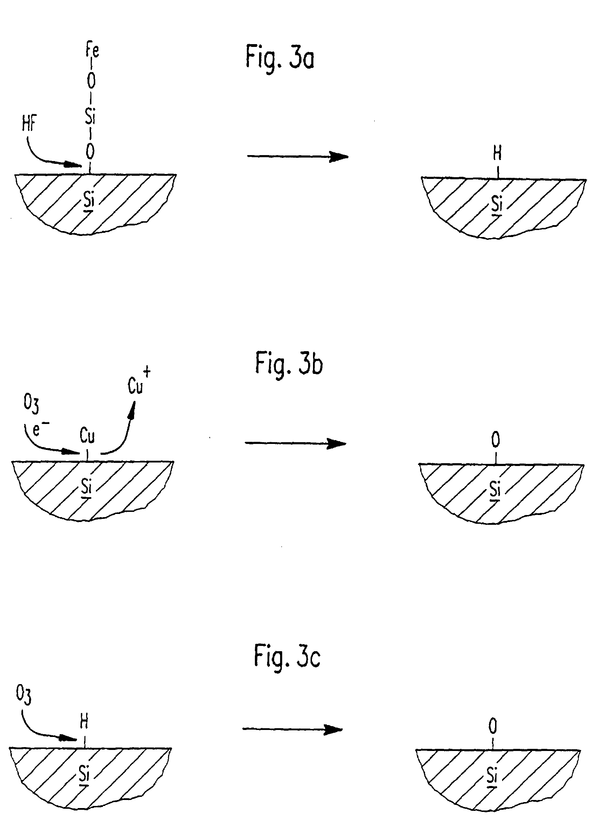

Fig. 3a shows that the HF solution in the aqueous solution guarantees the eroding of the silicon oxide layers into which metal ions like Fe may be embedded.

Metal contamination like Cu, which are directly connected to an Si atom, are removed by a Redox process, as shown in Fig. 3b.

Fig. 3c shows how the ozone causes the silicon surface to oxidize.

Thus, the silicon leaves the drying bath perfectly clean, hydrophilic and dry.

Other embodiments of the invention will be apparent to one of ordinary skill in the art. Although the preferred embodiments and examples describe the drying of silicon wafers, the invention is applicable to substrates of many materials in addition to silicon, such as metals, plastics, glasses, and ceramics. The term "substrate" is not limited to substrates that support electronic circuitry, but applies to any object supporting a surface, i. e. having any adequate physical form, such as the form of wafers, plates or discs. The invention is not limited to the specific examples and is defined by the following claims.

## Claims

1. A method of drying a substrate surface (1), comprising:
dipping the substrate into a liquid bath (2);
passing over the surface of the liquid bath a gas that is soluble in the liquid and that lowers the surface tension of the liquid when dissolved therein; and
separating the substrate (1) and the liquid (3) at a rate such that the difference in surface tension between the liquid having a first concentration of dissolved gas by the substrate surface and the liquid having a lower concentration of dissolved gas away from the substrate surface dries the substrate upon separation,
**characterized in,**
**that** the liquid of the liquid bath (2) comprises an aqueous HF solution (3) and the gas comprises an O₂/O₃ mixture.

2. The method according to one of the preceding claims,
**characterized in,**
**that** the liquid of the liquid bath (2) comprises an aqueous HF solution (3) with a concentration between about .001% and about 50%.

3. The method according to claim 2,
**characterized in,**
**that** the HF concentration in the aqueous solution is between about .01% and about 0.1%.

4. The method according to one of the preceding claims,
**characterized in,**
**that** the substrate comprises silicon.

5. The method according to one of the claims 1 to 3,
**characterized in,**
**that** the substrate comprises a ceramic material or a glass material.

6. The method according to one of the claims 1 to 3,
**characterized in,**
**that** wherein the substrate comprises a plastic material.

7. The method according to one of the claims 1 to 3,
**characterized in,**
**that** the substrate comprises a metal material.

8. The method according to one of the claims 1 to 3,
**characterized in,**
**that** the substrate comprises a laser disk.

9. The method according to any one of claims 1 to 8,
**characterized in,**
**that** the substrate (1) and the liquid bath (3) are separated by lifting the substrate out of the liquid bath.

10. The method according to any one of claims 1 to 8,
**characterized in,**
**that** the substrate (1) and the liquid bath are separated by draining the liquid from the bath (2).

11. The method according to any one of the preceding claims,
**characterized in,**
**that** the liquid bath (3) contains at least one additive selected from the group consisting of acids, organic acids, surfactants and solid additives.

12. The method of claim 11,
**characterized in,**
**that** said at least one additive is an acid selected from the group consisting of HCl, H₃PO₄, H₂SO₄, HClO, HClO₂, HClO₃ and HClO₄.

13. The method of claim 11,
**characterized in,**
**that** said aqueous solution contains a mixture of acids selected from the group consisting of HCl/H₂PO₄, H₃PO₄/HCl, H₃PO₄/H₂SO₄ and H₃PO₄/HCl/H₂SO₄.

14. The method of any one of claims 11 to 13,
**characterized in,**
**that** said acid is added to give a concentration of up to 50% by weight.

15. The method of claim 11,
**characterized in,**
**that** said at least one additive is an organic acid selected from the group consisting of formic acid, acetic acid and citric acid.

16. The method of claim 15,
**characterized in,**
**that** said organic acid is added to give a final concentration of up to about 80% by weight.

17. The method of claim 11,
**characterized in,**
**that** said surfactant is added to give a final concentration of up to about 5% by weight.

18. The method of claim 11,
**characterized in,**
**that** said solid additive is NH₄F.

19. The method of claim 11,
**characterized in,**
**that** said solid additive is added to give a final concentration of up to about 50% by weight.

20. The method according to any one of claims 1 to 19,
**characterized in,**
**that** the method is carried out at a temperature between 0 and 100 degrees Celsius.

21. The method according to claim 20,
**characterized in,**
**that** the method is carried out at a temperature between 20 and 50 degrees Celsius.

22. The method according to any one of the preceding claims,
**characterized in,**
**that** the proportion of O₃ in the O₂/O₃ gas mixture is between 1 mg and 0.5 g per liter of O₂/O₃ gas mixture.

## Patentansprüche

1. Verfahren zum Trocknen einer Substratoberfläche (1), mit
Eintauchen des Substrats in ein Flüssigkeitsbad (2);
Überstreichen der Oberfläche des Flüssigkeitsbades mit einem Gas, das in der Flüssigkeit löslich ist und das die Oberflächenspannung der Flüssigkeit verringert, wenn es darin gelöst ist; und
Trennen des Substrats (1) und der Flüssigkeit (3) in einer derartigen Geschwindigkeit, dass der Unterschied in der Oberflächenspannung zwischen der Flüssigkeit, die eine erste Konzentration gelösten Gases bei der Substratoberfläche aufweist, und der Flüssigkeit, die eine niedrigere Konzentration gelösten Gases von der Substratoberfläche entfernt aufweist, das Substrat beim Trennen trocknet,
**dadurch gekennzeichnet,**
**dass** die Flüssigkeit des Flüssigkeitsbades (2) eine wässrige HF-Lösung (3) aufweist und das Gas ein O₂/O₃-Gemisch aufweist.

2. Verfahren nach Anspruch 1,
**dadurch gekennzeichnet,**
**dass** die Flüssigkeit des Flüssigkeitsbades (2) eine wässrige HF-Lösung (3) mit einer Konzentration zwischen etwa 0,001 % und etwa 50 % aufweist.

3. Verfahren nach Anspruch 2,
**dadurch gekennzeichnet,**
**dass** die HF-Konzentration in der wässrigen Lösung zwischen etwa 0,01 % und etwa 0,1 % beträgt.

4. Verfahren nach einem der vorhergehenden Ansprüche,
**dadurch gekennzeichnet,**
**dass** das Substrat Silizium enthält.

5. Verfahren nach einem der Ansprüche 1 bis 3,
**dadurch gekennzeichnet,**
**dass** das Substrat ein Keramikmaterial oder ein Glasmaterial enthält.

6. Verfahren nach einem der Ansprüche 1 bis 3,
**dadurch gekennzeichnet,**
**dass** das Substrat ein Kunststoffmaterial enthält.

7. Verfahren nach einem der Ansprüche 1 bis 3,
**dadurch gekennzeichnet,**
**dass** das Substrat ein Metallmaterial enthält.

8. Verfahren nach einem der Ansprüche 1 bis 3,
**dadurch gekennzeichnet,**
**dass** das Substrat eine Laser Disk aufweist.

9. Verfahren nach einem der Ansprüche 1 bis 8,
**dadurch gekennzeichnet,**
**dass** das Substrat (1) und die Flüssigkeit (3) durch Heben des Substrats aus dem Flüssigkeitsbad getrennt werden.

10. Verfahren nach einem der Ansprüche 1 bis 8,
**dadurch gekennzeichnet,**
**dass** das Substrat (1) und die Flüssigkeit durch Ablassen der Flüssigkeit aus dem Bad (2) getrennt werden.

11. Verfahren nach einem der vorhergehenden Ansprüche,
**dadurch gekennzeichnet,**
**dass** die Flüssigkeit (3) wenigstens einen Zusatzstoff enthält, der ausgewählt ist aus der Gruppe bestehend aus Säuren, organischen Säuren, grenzflächenaktiven Stoffen und festen Zusatzstoffen.

12. Verfahren nach Anspruch 11,
**dadurch gekennzeichnet,**
**dass** der wenigstens eine Zusatzstoff eine Säure ist, die ausgewählt ist aus der Gruppe bestehend aus HCI, H₃PO₄, H₂SO₄, HClO, HClO₂, HClO₃ und HClO₄.

13. Verfahren nach Anspruch 11,
**dadurch gekennzeichnet,**
**dass** die wässrige Lösung ein Säuregemisch enthält, das ausgewählt ist aus der Gruppe bestehend aus HCl/H₃PO₄, H₃PO₄/HCl, H₃PO₄/H₂SO₄ und H₃PO₄/HCl/H₂SO₄.

14. Verfahren nach einem der Ansprüche 11 bis 13,
**dadurch gekennzeichnet,**
**dass** die Säure derart zugegeben wird, dass sich eine Konzentration von bis zu 50 Gew.% ergibt.

15. Verfahren nach Anspruch 11,
**dadurch gekennzeichnet,**
**dass** der wenigstens eine Zusatzstoff eine organische Säure ist, die ausgewählt ist aus der Gruppe bestehend aus Methansäure, Ethansäure und Zitronensäure.

16. Verfahren nach Anspruch 15,
**dadurch gekennzeichnet,**
**dass** die organische Säure derart zugegeben wird, dass sich eine Endkonzentration von bis zu etwa 80 Gew.% ergibt.

17. Verfahren nach Anspruch 11,
**dadurch gekennzeichnet,**
**dass** der grenzflächenaktive Stoff derart zugegeben wird, dass sich eine Endkonzentration von bis zu etwa 5 Gew.% ergibt.

18. Verfahren nach Anspruch 11,
**dadurch gekennzeichnet,**
**dass** der feste Zusatzstoff NH₄F ist.

19. Verfahren nach Anspruch 11,
**dadurch gekennzeichnet,**
**dass** der feste Zusatzstoff derart zugegeben wird, dass sich eine Endkonzentration von bis zu etwa 50 Gew.% ergibt.

20. Verfahren nach einem der Ansprüche 1 bis 19,
**dadurch gekennzeichnet,**
**dass** das Verfahren bei einer Temperatur zwischen 0 und 100 Grad Celsius durchgeführt wird.

21. Verfahren nach Anspruch 20,
**dadurch gekennzeichnet,**
**dass** das Verfahren bei einer Temperatur zwischen 20 und 50 Grad Celsius durchgeführt wird.

22. Verfahren nach einem der vorhergehenden Ansprüche,
**dadurch gekennzeichnet,**
**dass** der Anteil von O₃ in dem O₂/O₃-Gasgemisch zwischen 1 mg und 0,5 g je Liter des O₂/O₃-Gasgemisches beträgt.

## Revendications

1. Procédé de séchage de la surface d'un substrat (1), comprenant:
le trempage du substrat dans un bain liquide (2);
le passage sur la surface du bain liquide d'un gaz qui est soluble dans le liquide et qui abaisse la tension superficielle du liquide lorsqu'il y est dissous; et
séparant le substrat (1) et le liquide (3) à un taux tel que la différence de tension superficielle entre le liquide ayant une première concentration de gaz dissous par la surface du substrat et le liquide ayant une plus basse concentration de gaz dissous hors de la surface du substrat sèche le substrat dans la séparation,
**caractérisée en ce que** le liquide du bain liquide (2) est composé d'une solution aqueuse d'acide fluorhydrique (3) et le gaz est composé d'un mélange O₂/O₃.

2. Procédé selon l'une des revendications précédentes, **caractérisé en ce que**
le liquide du bain liquide (2) est composé d'une solution aqueuse d'acide fluorhydrique (3) avec une concentration entre environ 0,001% et environ 50%.

3. Procédé selon la revendication 2, **caractérisé en ce que**
la concentration d'acide fluorhydrique dans la solution aqueuse est entre environ 0,01% et environ 0,1%.

4. Procédé selon l'une des revendications précédentes, **caractérisé en ce que**
le substrat comprend du silicium.

5. Procédé selon l'une des revendications 1 à 3, **caractérisé en ce que**
le substrat comprend de la céramique ou du verre.

6. Procédé selon l'une des revendications 1 à 3, **caractérisé en ce que**
le substrat comprend du plastique.

7. Procédé selon l'une des revendications 1 à 3, **caractérisé en ce que**
le substrat comprend un métal.

8. Procédé selon l'une des revendications 1 à 3, **caractérisé en ce que**
le substrat comprend un disque laser.

9. Procédé selon l'une quelconque des revendications 1 à 8, **caractérisé en ce que**
le substrat (1) et le bain liquide (3) sont séparés en enlevant le substrat du bain liquide.

10. Procédé selon l'une quelconque des revendications 1 à 8, **caractérisé en ce que**
le substrat (1) et le bain liquide sont séparés en égouttant le liquide du bain (2).

11. Procédé selon l'une quelconque des revendications précédentes, **caractérisé en ce**
**que** le bain liquide (3) contient au moins un additif choisi parmi le groupe constitué par des acides, des acides organiques, des agents de surface et des additifs solides.

12. Procédé selon la revendication 11, **caractérisé en ce que**
ledit au moins un additif est un acide choisi parmi le groupe constitué par HCl, H₃PO₄,H₂SO₄, HClO, HClO₂, HClO₃ et HClO₄.

13. Procédé selon la revendication 11, **caractérisé en ce que**
ladite solution aqueuse contient un mélange d'acides choisis parmi le groupe constitué par HCl/H₂PO₄, H₃PO₄/HCl, H₃PO₄/H₂SO₄, et H₃PO₄/HCl/H₂SO₄.

14. Procédé selon l'une quelconque des revendications 11 à 13, **caractérisé en ce que**
ledit acide est ajouté pour donner une concentration de jusqu'à 50% en poids.

15. Procédé selon la revendication 11, **caractérisé en ce que**
ledit au moins un additif est un acide organique choisi parmi le groupe constitué par l'acide formique, l'acide acétique et l'acide citrique.

16. Procédé selon la revendication 15, **caractérisé en ce que**
ledit acide organique est ajouté pour donner une concentration finale de jusqu'à environ 80% en poids.

17. Procédé selon la revendication 11, **caractérisé en ce que**
ledit agent de surface est ajouté pour donner une concentration finale de jusqu'à environ 5% en poids.

18. Procédé selon la revendication 11, **caractérisé en ce que**
ledit additif solide est NH₄F.

19. Procédé selon la revendication 11, **caractérisé en ce que** .
ledit additif solide est ajouté pour donner une concentration finale de jusqu'à environ 50% en poids.

20. Procédé selon l'une quelconque des revendications 1 à 19, **caractérisé en ce que**
le procédé est réalisé à une température entre 0 et 100 degrés Celsius.

21. Procédé selon la revendication 20, **caractérisé en ce que**
le procédé est réalisé à une température entre 20 et 50 degrés Celsius.

22. Procédé selon l'une quelconque des revendications précédentes, **caractérisé en ce que**
la proportion de O₃ dans le mélange de gaz O₂/O₃ est entre 1 mg et 0,5 g par litre de mélange de gaz O₂/O₃.
